# EUROPEAN PATENT APPLICATION

(11) **EP 3 139 369 A1**
(43) Date of publication of application: **08.03.2017**
(21) Application number: 15183591.5
(22) Date of filing: 02.09.2015
(51) Int. Cl.: G09G 3/00, F21V 7/00, H04N 9/31, G09G 3/20

(54) **PRINTED CIRCUIT BOARD FOR CONTROLLING PROJECTORS AND ELECTRONIC DEVICE**

(71) Applicant: TP Vision Holding B.V., 1097 JB Amsterdam (NL)
(72) Inventor: Bruyneel, Filip Marcel Denise, B-9052 Ghent (BE); Verdin, Maxime Léon Marie Joseph, B-9052 Ghent (BE); Spaenhoven, Stefan Eugeen, B-9052 Ghent (BE); Standaert, Thomas, B-9052 Ghent (BE); Boudringhien, Julie Pauline Nelly, B-9052 Ghent (BE); Delacroix, Danny Arnoldus Julomain, B-9052 Ghent (BE)
(74) Representative: DREISS Patentanwälte PartG mbB

(57) **Abstract**

The invention relates to a printed circuit board (1). The printed circuit board (1) comprises multiple light engine controllers (5) and a content processor (3). Each of the multiple light engine controllers (5) is operative to control a light source and a display of at least one corresponding projector (7). The content processor (3) is operative to receive a content signal and to provide a part of this content signal to each of the multiple light engine controllers (5). A part of the content signal provided to a light engine controller (5) depends on the position of the light engine controller (5). The invention further relates to an electronic device comprising such a printed circuit board (1).

## Description

### Field of the invention

The invention relates to a printed circuit board for controlling projectors.

The invention further relates to an electronic device comprising a printed circuit board for controlling projectors.

### Background of the invention

WO2010/133992 A2 discloses a (flexible) printed circuit board for controlling light emitting diodes (LEDs). The printed circuit board comprises light emitting diode circuits and other circuitry including a driver for driving the light emitting diode circuits individually for providing ambient light for a display screen. Multiple flexible printed circuit boards are placed along edges of the display screen

A drawback of this printed circuit board is that it cannot be used with projection ambient lighting, which can generate higher resolution ambient lighting effects than LED ambient lighting.

### Summary of the invention

It is a first object of the invention to provide a printed circuit board, which is suitable for controlling projectors to provide ambient light around a display screen.

It is a second object of the invention to provide an electronic device, which comprises a printed circuit board suitable for controlling projectors to provide ambient light around a display screen.

According to the invention, the first object is realized in that the printed circuit board comprises a plurality of light engine controllers, each of said plurality of light engine controllers being operative to control a light source and a display of at least one corresponding projector, and a content processor operative to receive a content signal and to provide a part of said content signal to each of said plurality of light engine controllers, wherein a part of said content signal provided to a light engine controller depends on the position of said light engine controller.

Projectors require input with a significantly higher resolution than LEDs. By integrating the content processor and the light engine controllers on one printed circuit board, complex wiring and additional content processors, e.g. FPGAs, near the light engine controllers can be avoided. Said content signal may comprise a video signal and/or an audio signal.

Each of said plurality of light engine controllers may be operative to send a high frequency display signal to said at least one corresponding projector for controlling said display of said at least one corresponding projector. Said high frequency display signal may comprise at least one of a TTL signal, a CMOS signal and an LVDS signal. A high frequency display signal is able to carry the significantly higher resolution input required by the projectors.

Each of said plurality of light engine controllers may be operative to send a signal comprising pulse-width and/or amplitude modulated currents to said at least one corresponding projector for controlling said light source of said at least one corresponding projector. These pulse-width and/or amplitude modulated currents can be used to drive power to the light source, e.g. LEDs, of the projector.

Said part of said content signal provided by said content processor to said light engine controller may depend on the position of said light engine controller with reference to said printed circuit board. If the printed circuit board is always installed in an electronic device at approximately the same position and with approximately the same orientation, it is not necessary to configure a mapping between a part of the content signal and a light engine controller. For example, a light engine controller positioned at the left side of the printed circuit board may always control a projector that projects ambient light to the left of a display device and this light engine controller can therefore always be sent a left part of the content signal.

Said part of said content signal provided by said content processor to said light engine controller may comprise ambient lighting effects determined from said content signal by said content processor. By implementing the algorithm to create ambient light effects in said content processor, an additional printed circuit board can be avoided.

According to the invention, the second object is realized in that the electronic device comprises the printed circuit board of the invention.

The electronic device may further comprise said projectors corresponding to said each of said plurality of light engine controllers. Although the projectors could alternatively be add-on devices, incorporating them into the electronic device achieves optimal ambient lighting effects without a complicated installation.

The electronic device may comprise a display screen. Said projectors may be operative to provide an ambient lighting effect behind said electronic device around said display screen. In this way, the ambient lighting effects are most effective and least intrusive.

Said part of said content signal provided by said content processor to said light engine controller may depend on the position of said light engine controller with reference to said electronic device. If the printed circuit board is not always installed in an electronic device at approximately the same position and with approximately the same orientation, it is advantageous to allow configuration of a mapping between a certain part of said content signal and a certain light engine controller, so that said part of said content signal will depend on the position of said light engine controller with reference to said electronic device. For example, a left part of said content signal may be mapped to a light engine controller on the left side of the electronic device (as seen from in front of the electronic device).

### Brief description of the Drawings

These and other aspects of the invention are apparent from and will be further elucidated, by way of example, with reference to the drawings, in which:
- Fig.1 is a block diagram of the printed circuit board of the invention;
- Fig.2 is a block diagram of an embodiment of the printed circuit board of the invention; and
- Fig.3 is a block diagram of the electronic device of the invention.

Corresponding elements in the drawings are denoted by the same reference numeral.

### Detailed description of the Drawings

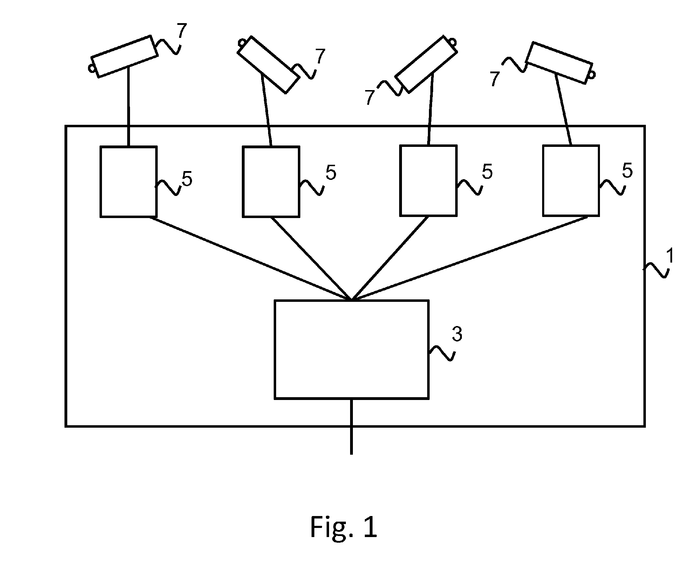

The printed circuit board 1 for controlling projectors of the invention comprises a plurality of light engine controllers 5 and a content processor 3, see Fig.1. Each of the plurality of light engine controllers 5 is operative to control a light source and a display of at least one corresponding projector 7. The content processor 3 is operative to receive a content signal and to provide a part of the content signal to each of the plurality of light engine controllers 5, wherein a part of the content signal provided to a light engine controller 5 depends on the position of the light engine controller 5. The content processor 3 may be an image and/or audio processor, for example. The content processor 3 may be a suitably programmed Xilinx Spartan-6 LX100 FPGA, for example. The projector 7 may be a pico-projector light engine based on e.g. a Texas Instruments .2" nHD, .24" VGA or .3" WVGA DMD and using e.g. OSRAM LED light sources like LE BA Q6WM and LCG H9RM, for example.

The projectors 7 are preferably positioned at suitable positions on an electronic device comprising a display screen. The display screen may be an LCD or OLED panel or a backlight projection screen, for example. The projectors should not be positioned near an edge of the display device. Since the light engine controllers 5 and content processor 3 need to fit on one PCB, the printed circuit board should not be too small and the components need to be positioned sufficiently close to each other. The printed circuit board 1 has a mechanical outline to allow positioning of projector connectors on the printed circuit board 1 close to the projectors 7 in order to limit the length of the cables going from light engine controllers 5 to projectors 7. A light engine controller 5 performs functions that are specific to a connected projector 7. A light engine controller 5 can control one or more projectors 7. A light engine controller 5 typically converts the standardized video-format that is output by the content processor 3 to suitable control signals for the pixels of the display of the corresponding projector 7 and ensures correct synchronization with the control signals for the light source of the corresponding projector 7.

In an embodiment, the part of the content signal provided by the content processor 3 to the light engine controller 5 depends on the position of the light engine controller 5 with reference to the printed circuit board 1. The content processor 3 splits the content signal towards the different light engine controllers 5, e.g. a left part of a video signal is sent to a light engine controller that controls a projector that projects left of a display screen and a right part of the video signal is sent to a projector that projects rights of the display screen. In the same or in a different embodiment, the part of the content signal provided by the content processor 3 to the light engine controller 5 comprises ambient lighting effects determined from the content signal by the content processor 3. In a simple implementation, groups of pixels in which pixels in a group can have different values are converted into groups of pixels in which all pixels in a group have the same value, thereby creating a content signal that abstracts from finer (image) details.

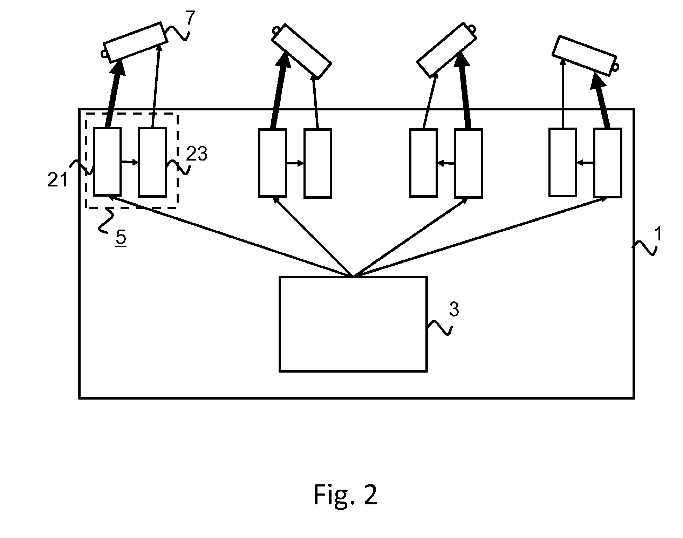

In the embodiment of the printed circuit board 1 shown in Fig.2, each of the plurality of light engine controllers 5 comprises components 21 and 23. Component 21 is operative to send a high frequency display signal to the at least one corresponding projector 7 for controlling the display of the at least one corresponding projector 7. The high frequency display signal may comprise a TTL signal, a CMOS signal or an LVDS signal. Component 23 is operative to send a signal comprising pulse-width and/or amplitude modulated currents to the at least one corresponding projector 7 for controlling the light source, e.g. LEDs, of the at least one corresponding projector 7. Component 21 may be a Texas Instruments DLPC2607 DLP Pico processor, for example, Component 23 may be a Texas Instruments PAD1000 LED controller, for example.

A non-volatile (e.g. flash) memory may be used to store calibration, e.g. color alignment, information. This non-volatile memory may be incorporated into the printed circuit board 1, into the projector 7 or into a cable between the printed circuit board 1 and the projector 7. Projector-specific calibration information, e.g. obtained by the projector supplier by using a calibration process in the production process, is preferably stored near the projector 7, e.g. in the projector 7 or on a cable to the projector 7, and read by the light engine controller 5. Calibration information that is not projector-specific is preferably stored on the printed circuit board 1 or on a microcontroller or video platform coupled to the printed circuit board 1. The projector specific calibration information can also be stored on a central location of the printed circuit board 1 in case the calibration is performed for an assembled system as described in Fig. 2.

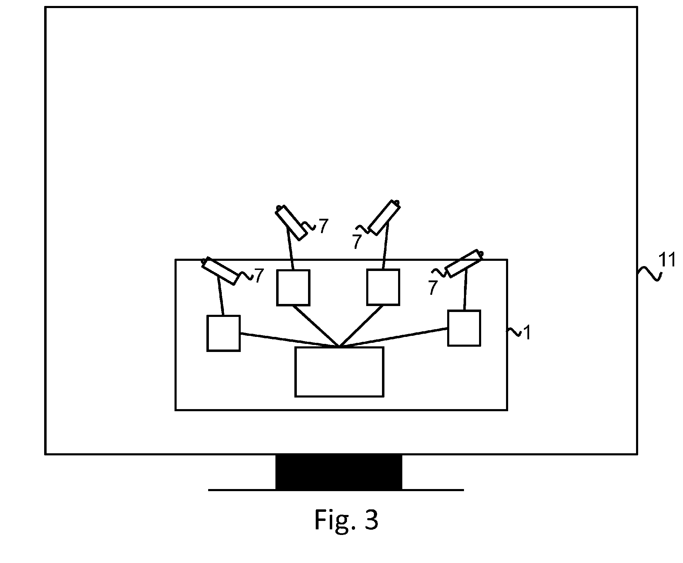

The electronic device 11 of the invention comprises the printed circuit board 1 of the invention, see Fig.3. In an embodiment, the electronic device 11 further comprises the projectors 7 corresponding to each of the plurality of light engine controllers 5. In the same embodiment or in a different embodiment, the electronic device 11 may further comprise a display screen (not shown). The projectors 7 may be operative to provide an ambient lighting effect behind the electronic device 11 around the display screen.

In the same or in a different embodiment, the part of the content signal provided by the content processor 3 to the light engine controller 5 depends on the position of the light engine controller 5 with reference to the electronic device 11. For example, it may be possible to configure a mapping between a certain part of a video signal and a certain light engine controller, e.g. to allow the exact bottom-left part of said video signal to be mapped to a first light engine controller and the exact top-left part of said video signal to be mapped to a second light engine controller. By mapping the exact part of the video signal to the corresponding light engine, it is possible to ensure that the image projected by the corresponding light engine fits in the picture projected by the whole system and to avoid any visual artefact or interruption (e.g. black areas, double pixels, deformation and bright lines) in the picture projected by the whole system. This mapping may be stored in flash memory, for example.

A light engine controller 5 may be coupled to the light source of the corresponding projector 7 over a flat cable or wired cable, for example. A flat cable may be preferred when a high power is not needed and a compact connector is desired and a wired cable may be preferred when high power is needed and/or a bigger connector is acceptable, for example. Such a cable may be flexible, rigid or partly flexible. A light engine controller 5 may be coupled to the display of the corresponding projector 7 over a flexible printed circuit (FPC) or a rigid printed circuit board or a partly flexible printed circuit board. A light engine controller 5 may be coupled to the light source and the display of the corresponding projector 7 over the same cable or circuitry. A projector 7 may have screw holes that allow a printed circuit board to be mounted on the projector 7. This printed circuit board may on one side comprise a first connector for connecting to (e.g. the display of) the projector 7. On the other side, the printed circuit board may comprise a second connector, preferably of a different type, for connecting to a light engine controller 5. This allows the manufacturer of the printed circuit board 1 to use a cable of its choosing to connect a light engine controller 5 to a (printed circuit board mounted on a) projector 7.

For reasons of electromagnetic interference and signal integrity, the length of the (FPC) cable between a light engine controller 5 and the display of the projector 7 should have a certain maximum length, preferably between approximately 10cm and approximately 20 cm. This maximum length includes the trace length from the light engine controller 5 to the projector connector on the printed circuit board 1, the distance in the projector connector, the distance on the (FPC) cable and the distance on the interface to the display on the projector.

While the invention has been described in connection with preferred embodiments, it will be understood that modifications thereof within the principles outlined above will be evident to those skilled in the art, and thus the invention is not limited to the preferred embodiments but is intended to encompass such modifications. The invention resides in each and every novel characteristic feature and each and every combination of characteristic features. Reference numerals in the claims do not limit their protective scope. Use of the verb "to comprise" and its conjugations does not exclude the presence of elements other than those stated in the claims. Use of the article "a" or "an" preceding an element does not exclude the presence of a plurality of such elements.

'Means', as will be apparent to a person skilled in the art, are meant to include any hardware (such as separate or integrated circuits or electronic elements) or software (such as programs or parts of programs) which perform in operation or are designed to perform a specified function, be it solely or in conjunction with other functions, be it in isolation or in co-operation with other elements. The invention can be implemented by means of hardware comprising several distinct elements, and by means of a suitably programmed computer. The mere fact that certain measures are recited in mutually different dependent claims does not indicate that a combination of these measures cannot be used to advantage.

## Claims

1. A printed circuit board (1) for controlling projectors, comprising:
a plurality of light engine controllers (5), each of said plurality of light engine controllers (5) being operative to control a light source and a display of at least one corresponding projector (7); and
a content processor (3) operative to receive a content signal and to provide a part of said content signal to each of said plurality of light engine controllers (5), wherein a part of said content signal provided to a light engine controller (5) depends on the position of said light engine controller (5).

2. A printed circuit board (1) as claimed in claim 1, wherein each of said plurality of light engine controllers (5) is operative to send a high frequency display signal to said at least one corresponding projector (7) for controlling said display of said at least one corresponding projector (7).

3. A printed circuit board (1) as claimed in claim 2, wherein said high frequency display signal comprises at least one of a TTL signal, a CMOS signal and an LVDS signal.

4. A printed circuit board (1) as claimed in any of the preceding claims, wherein each of said plurality of light engine controllers (5) is operative to send a signal comprising pulse-width and/or amplitude modulated currents to said at least one corresponding projector (7) for controlling said light source of said at least one corresponding projector (7).

5. A printed circuit board (1) as claimed in any of the preceding claims, wherein said part of said content signal provided by said content processor (3) to said light engine controller (5) depends on the position of said light engine controller (5) with reference to said printed circuit board (1).

6. A printed circuit board (1) as claimed in any of the preceding claims, wherein said part of said content signal provided by said content processor (3) to said light engine controller (5) comprises ambient lighting effects determined from said content signal by said content processor (3).

7. An electronic device (11) comprising the printed circuit board (1) of any of claims 1 to 6.

8. An electronic device (11) as claimed in claim 7, further comprising said projectors (7) corresponding to said each of said plurality of light engine controllers (5).

9. An electronic device (11) as claimed in claim 7 or 8, wherein said electronic device comprises a display screen.

10. An electronic device (11) as claimed in claim 9, wherein said projectors (7) are operative to provide an ambient lighting effect at least behind said electronic device (11) around said display screen.

11. An electronic device (11) as claimed in any of the preceding claims, wherein said part of said content signal provided by said content processor (3) to said light engine controller (5) depends on the position of said light engine controller (5) with reference to said electronic device (11).
